(19) Europäisches Patentamt European Patent Office Office européen des brevets

(11) **EP 4 290 766 A1**

(12) **EUROPEAN PATENT APPLICATION**

(43) Date of publication:
**13.12.2023 Bulletin 2023/50**

(21) Application number: **22305818.1**

(22) Date of filing: **06.06.2022**

(51) International Patent Classification (IPC):
**H03C 1/08** *(2006.01)*     **H03C 3/40** *(2006.01)*
**H03C 5/00** *(2006.01)*

(52) Cooperative Patent Classification (CPC):
**H03C 5/00; H03C 1/08; H03C 3/40**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **BULL SAS**
**78340 Les Clayes-Sous-Bois (FR)**

(72) Inventor: **LEZAUD, Nicolas**
**13450 GRANS (FR)**

(74) Representative: **IPAZ**
**Bâtiment Platon**
**Parc Les Algorithmes**
**91190 Saint-Aubin (FR)**

(54) **A MODULATOR AND A METHOD FOR MODULATING THE PHASE OF A RADIOFREQUENCY SIGNAL**

(57)    The invention relates to a modulator (100) for modulating the phase and the amplitude of a radiofrequency signal (Sin), called input signal, said modulator (100) comprising:
- a splitter (102) for splitting the input signal (Sin) into a first signal (S1) and a second signal (S2);
- an assembly (104) comprising:
  ▪ at least one individual phase shifter (110;114) for individually shifting the phase of at least one of the first and second signals (S1,S2) in order to obtain in phase quadrature first and second signals, and
  ▪ at least one individual attenuator (112,116) for individually adjusting the amplitude of at least one of the first and second signals (S1,S2);

- a combiner (118) for combining said in phase quadrature first and second signals (S1,S2) output by said assembly (104), and delivering a combined signal (Sc); and
- a global phase shifter (120) for applying a phase shift to said combined signal (Sc) and delivering an output signal (Sout).
The invention further relates to a method and a computer program for modulating the phase of a radiofrequency signal (Sin).

FIG. 1

## Description

### Field of the invention

The present invention relates to a phase modulator for modulating the phase of a radiofrequency signal, and in particular of a microwave signal. The invention also relates to a method for modulating the phase of a radiofrequency signal, with such a modulator, and the use of a such a modulator for simulating the direction of arrival of a received signal, or the direction of emission of an emitted signal.

The field of the invention is the field of phase modulator for radiofrequency signals.

### Background

It is well known that the direction of arrival, or the direction of emission, of a radiofrequency, RF, signal may be simulated by phase modulation of said signal.

Such a phase modulation of a signal may be done with a vector modulator. The signal is input in the vector modulator, which, in turn, outputs an output signal with a phase shift that is chosen in the vector modulator. A vector modulator allows independent adjustment of the phase and of the amplitude, so that the phase and the amplitude may also be controlled independently. But, a standard vector modulator has a low bandwidth. A wide bandwidth requires specific vector modulator, or and assembly of several vector modulators, which is very expensive.

Another solution for phase modulation of a RF signal consists in using a system combining a phase shifter and a variable attenuator. Such a system has the advantage of being cheaper compared to a vector modulator, in particular for wide bandwidth applications. But, in a such a system the phase and the gain are tied so that the change of the phase modifies the gain, *vice versa.* This amounts to a time consuming and complicated calibration of the system.

A purpose of the present invention is to overcome at least one of these drawbacks.

Another purpose of the invention is to provide a solution for phase modulating a RF signal that is cheaper and easier to calibrate compared to the solutions of the prior art, especially for wide bandwidth applications.

### Summary of the invention

The invention makes it possible to achieve at least one of these aims by a modulator for modulating the phase and the amplitude of a radiofrequency signal, called input signal, said modulator comprising:

- a splitter for splitting the input signal into a first signal and a second signal;
- an assembly comprising:

  ▪ at least one individual phase shifter for individually shifting the phase of at least one of the first and second signals in order to obtain in phase quadrature first and second signals, and
  ▪ at least one individual attenuator for individually adjusting the amplitude of at least one of the first and second signals;

- a combiner for combining said in phase quadrature first and second signals output by said assembly, and delivering a combined signal; and
- a global phase shifter for applying a phase shift to said combined signal and delivering an output signal.

The present invention proposes a modulator that may be developed with conventional components that are more affordable compared to a vector modulator, such as phase shifter(s), attenuator(s), splitter(s) and combiner(s). Thus, the modulator of the present invention is less expensive compared to vectors modulators, especially for wide bandwidth applications, for example of an octave.

Plus, in the modulators of the prior art combining a phase shifter and an attenuator, it is necessary to calibrate the modulator for many points, each corresponding to a combination of a phase shift and amplitude shift for the input signal, which is very time consuming. The modulator according to the invention requires a less time consuming calibration.

Indeed, in the modulator according to the invention, the input signal is split into two signals that are processed independently in order to get in phase quadrature first and second signals: there is a phase shift of 90° between the first signal and the second signal. Plus, the modulator according to the invention allows individual control of the amplitude of the first signal and/or individual control of the amplitude if the second signal. Thus, the phase and the amplitude of the combined signal, provided by the combiner, are given by the following relations:

$$\angle V\_r = \arctan V\_{(90°)}/V\_{(0°)} \quad \textbf{Relation 1}$$

$$|V\_r| = \sqrt{(|V\_{(90°)}^2| + |V\_{(0°)}^2|)} \quad \textbf{Relation 2}$$

Thus, the phase and the amplitude of the combined signal may be adjusted easily by adjusting the amplitude of the first and the second signals, making the calibration of the modulator easier and faster.

According to some embodiments, the global phase shifter may be an adjustable, or controllable, phase shifter.

Thus, it is possible to adjust the phase shift of the output signal to a desired value. The desired phase shift is applied to the combined signal, which is much more easy to calibrate compared to phase shifts applied to each way of the systems of the prior art.

In some embodiments, the global phase shifter may be a 0-360° phase shifter.

Thus, the modulator according to the invention makes it possible to modulate the phase of the input signal to a desired value that is between 0° and 360°, i.e. to cover the whole range of phase values for a RF signal.

In some embodiments, the assembly may comprise a first path dedicated to the first signal and a second path dedicated to the second signal.

Thus the first signal and the second signal are processed individually.

Plus, with dedicated paths to the first signal and to the second signal it is possible to process the first and the signals in parallel.

In some embodiments, the assembly may comprise:

- an individual phase shifter for the first signal, and
- an individual phase shifter for the second signal.

Thus, it possible to intervene on the phase shift applied to each of the the first and second signals individually without interfering on the other signal.

In some embodiments, at least one, and in particular each of, the individual phase shifter is an adjustable, or controllable, phase shifter. Thus, it is possible to adjust the phase shift applied to at least one of the first and second signals individually in order to get the first signal and the second signal in phase quadrature.

In some embodiments, at least one of the individual phase shifters may be a 0-360° phase shifter.

Thus it is possible to apply a desired phase shift to at least one, and in particular each, of the first and the second signals in order the get these signals in phase quadrature. In other words, it is possible to apply a desired phase shift to the first and/or the second signal, as long as the phase difference between the two signal is equal to 90°.

In some embodiments, the assembly may comprise:

- an individual attenuator for the first signal, and
- an individual attenuator for the second signal;

Such individual attenuators make it possible to intervene on the amplitude of each of the first and second signals individually.

On the one hand, when applying a phase shift on a signal, i.e. the first or the second signal, with the individual phase shifter, the gain of the signal is modified by said phase shifter because the phase shifter is not a perfect phase shifter. The individual attenuator may thus be used to balance the modification of the gain induced by the phase shifter.

On the other hand, and above all the phase of the combined signal issued by the combiner is directly related to the amplitude of the first and to the amplitude of the second signal, as indicated above (see Relation 1). Thus, the individual attenuators used to individually adjust the amplitude of the first signal and the amplitude of the second signal make it possible to adjust the phase of the combined signal issued by the combiner, and thus the phase of the output signal output by the modulator according to the invention.

In some embodiments, at least one, and in particular each of, the individual attenuators is an adjustable, or controllable, attenuator. Thus, it is possible order to get the first signal and the second signal in phase quadrature.

At least one component of the modulator according to the invention, i.e. at least one of the splitter, the combiner, the common phase shifter, the individual phase shifter(s) and the attenuator(s), may be a hardware component.

At least one component of the modulator according to the invention, i.e. at least one of the splitter, the combiner, the common phase shifter, the individual phase shifter(s) and the attenuator(s), may be a software component.

At least one component of the modulator according to the invention, i.e. at least one of the splitter, the combiner, the common phase shifter, the individual phase shifter(s) and the attenuator(s), may be an individual component.

At least two components of the modulator according to the invention, i.e. at least two of the splitter, the combiner, the common phase shifter, the individual phase shifter(s) and the attenuator(s), may be integrated or combined in a single component.

The modulator according to the invention may also comprise a controller for adjusting or controlling:

- the phase shift applied to the input signal, and
- optionally, the amplitude of the output signal Sout.

To do this, the controller may be configured to control/adjust:

- the phase shift applied by the global phase shifter, and
- the relative amplitude of the first and the second signal. For example, the controller may adjust/control the gain of at least one, and in particular each, of the individual attenuators.

In some embodiments, the controller may be configured to control the global phase shifter, each individual phase shifter and each individual attenuator.

The controller may be any electronic or computerized unit such as a processor, a calculator, an electronic chip, a computer, etc.

According to another aspect of the same invention, it is proposed a use of a modulator for simulating:

- a direction of arrival of a received RF signal, or
- a direction of emission of an emitted RF signal;

by modulating the phase, and optionally the amplitude, of said RF signal.

According to another aspect of the same invention, it is proposed a method for modulating the phase and the amplitude of a radiofrequency, RF, signal, called input signal, with a modulator according to the invention, said method comprising the following steps:

- splitting the input signal into a first signal and a second signal;
- phase shifting for applying a 90° phase difference between said first and second signals, and delivering in phase quadrature first and second signals;
- adjusting relative amplitudes of said first and second signals,
- combining said in phase quadrature first and second signals and delivering a combined signal; and
- applying a phase shift to said combined signal and delivering an output signal.

The method according to the invention may further comprise at least one of the optional features, or any combination of said optional features, indicated above with respect to the modulator according to the invention, that are not repeated here for sake of brevity.

Moreover, in some embodiments, the method according of the invention may further comprise a calibration phase of the modulator for at least one desired phase shift value.

The calibration phase may comprise the following steps:

- the individual phase shifter(s) and the individual attenuator(s) of the assembly are adjusted to obtain in phase quadrature first and second signals;
- the individual attenuator(s) of the assembly is(are) adjusted independently, and the amplitude and the added phase shifting from 90° is recorded for each path;
- the individual phase shifter(s) are adjusted independently over a short range and the added amplitude is recorded;
- the range of the individual attenuator(s) and individual phase shifter(s) which could be used are determined by the added phase shifting and added amplitude depending on the required precision. The phase and the amplitude are controlled according to the following relations:

$$\angle V_r = arctan\frac{V_{90°}}{V_{0°}}$$

$$|V_r| = \sqrt{\left|V_{90°}^2\right| + \left|V_{0°}^2\right|}$$

with $\angle V_r$ the phase of the combined signal issued by the combiner and $|V_r|$ the amplitude of the combined signal issued by the combiner;

- the global phase shifter is adjusted, in particular over 360°, and the induced amplitude change is compensated by the individual phase shifter(s) and the individual attenuator(s).

According to another aspect of the same invention, it is proposed a computer program comprising instructions, which when executed by a computer, cause the computer to carry out:

- the steps of the method according to the invention, or
- the functions carried out by the modulator according to the invention.

The computer program may be in any programming language such as C, C++, JAVA, Python, etc.

The computer program may be in machine language.

The computer program may be stored, in a non-transient memory, such as a USB stick, a flash memory, a hard-disc, a processor, a programmable electronic chop, etc.

The computer program may be stored in a computerized device such as a Smartphone, a tablet, a computer, a server, etc.

## Description of the figures and embodiments

Other advantages and characteristics will become apparent on examination of the detailed description of an embodiment which is in no way limitative, and the attached figures, where:

- Figure 1 is a diagrammatic representation of a non-limitative example of a modulator according to the invention;
- Figure 2 is a diagrammatic representation of another non-limitative example of a modulator according to the invention; and
- Figure 3 is a diagrammatic representation of a non-limitative example of a method according to the present invention.

It is well understood that the embodiments that will be described below are in no way limitative. In particular, it is possible to imagine variants of the invention comprising only a selection of the characteristics described hereinafter, in isolation from the other characteristics described, if this selection of characteristics is sufficient to confer a technical advantage or to differentiate the invention with respect to the state of the prior art. Such a selection comprises at least one, preferably functional, characteristic without structural details, or with only a part of the structural details if this part alone is sufficient to confer a technical advantage or to differentiate the invention with respect to the prior art.

In the FIGURES, elements common to several figures retain the same reference.

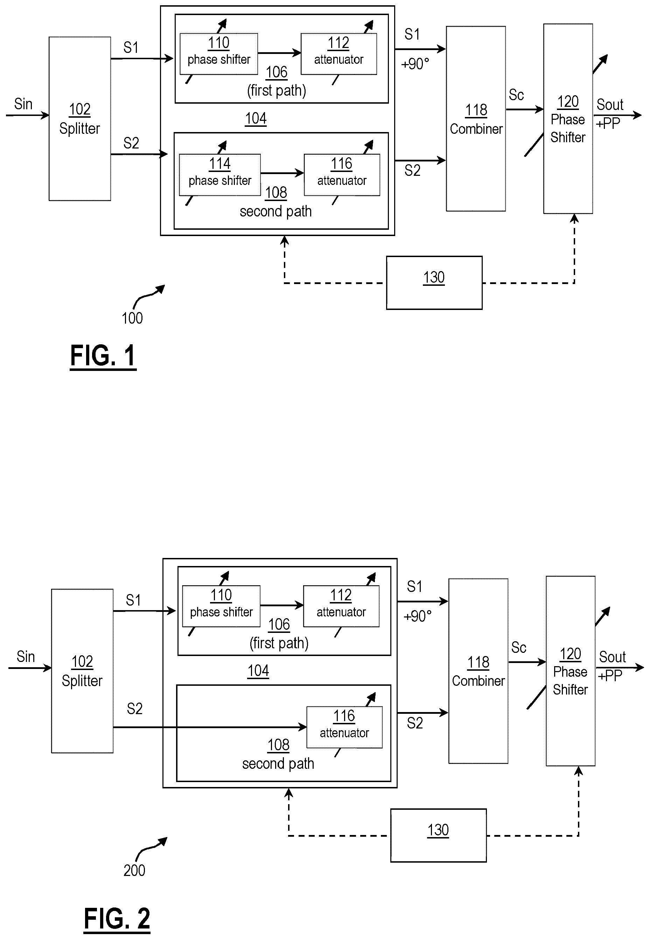

FIGURE 1 is a diagrammatic representation of a non-limitative example of a modulator according to the present invention.

The modulator 100, shown in FIGURE 1, may be used to modulate the phase of a RF signal, and in particular of a microwave signal, Sin, in order to obtain an output signal, Sout, on the FIGURE 1, the phase of which is shifted.

The modulator 100 comprises a splitter 102 for splitting the input signal Sin into a first signal S1 and a second signal S2 having the same amplitude. The splitter 102 may be a conventional splitter. In theory, an ideal splitter should not introduce a phase shift between the first signal S1 and S2, but in fact the splitter 102 introduces a small phase shift and a small amplitude gap, between the first signal S1 and the second signal S2.

The first signal S1 and the second signal S2 are then processed in an assembly 104 for introducing a 90° phase difference between said first signal S1 and said second signal S2, and delivering in phase quadrature first and second signals S1, S2. The phase shifting assembly 104 may be realized with conventional components and may be any phase shifting assembly.

In the example shown in FIGURE 1, the phase shifting assembly 104 comprises a first path 106, dedicated to the first signal S1, for processing the first signal S1 individually and independently of the second signal S2. The phase shifting assembly 104 also comprises a second path 108, dedicated to the second signal S2, for processing the second signal S2 individually and independently of the first signal S1.

The assembly 104 comprises, for the first signal S1:

- an individual phase shifter 110, and in particular a 0-360° adjustable and controllable phase shifter 110: this phase shifter 110 is used to modify the phase of the first signal S1; and
- an individual attenuator 112, and in particular an adjustable and controllable attenuator 112: this attenuator 112 is used to modify the amplitude of the first signal S1.

In a similar way, the assembly 104 comprises, for the second signal S2:

- an individual phase shifter 114, and in particular a 0-360° adjustable and controllable phase shifter 114: this phase shifter 110 is used to modify the phase of the second signal S2; and
- an individual attenuator 116, and in particular an adjustable and controllable attenuator 116: this attenuator 116 is used to modify the amplitude of the second signal S1.

Thus, in the assembly the phase and the amplitude of the first signal are adjusted independently from the phase and the amplitude of the second signal S2.

The in phase quadrature signals S1 and S2 are combined in a combiner 118. If the signals S1 and S2 have a phase difference of 90°, the combiner will provide a combined signal Sc, whose phase and amplitude are given by the following relations:

$$\angle V_r = arctan\frac{V_{90°}}{V_{0°}},$$

for the phase

$$|V_r| = \sqrt{\left|V_{90°}^2\right| + \left|V_{0°}^2\right|},$$

for the amplitude.

It is easily understood that, the phase of the combined signal Sc output by the combiner 118 may be adjusted by adjusting:

- the amplitude of the first signal S1, noted $V_{90°}$ in the relation above, and/or
- the amplitude of the second signal S2, noted $V_{0°}$ in the relation above.

The amplitude of the combined signal Sc output by the combiner 118 may also be adjusted by adjusting:

- the amplitude of the first signal S1, noted $V_{90°}$ in the relation above, and/or
- the amplitude of the second signal S2, noted $V_{0°}$ in the relation above.

The modulator 100 also comprises a global phase shifter 120, and in particular a 0-360° adjustable and controllable phase shifter 120, applying a desired phase shift, PP, to the combined signal Sc and provide an output signal Sout corresponding to the input signal Sin with the desired phase shift PP, and optionally a desired amplitude shift.

Thus, in the modulator 100, there is only needed a unique phase difference of 90° between the two ways, i.e. between the first signal S1 and the second signal S2, to obtain in phase quadrature signals. When the in phase quadrature signals are obtained a desired phase shift may be applied to the combined signal by adjusting the amplitude of the first and the second signals. Thus, the calibration of the modulator 100 is much easier and much less time consuming, compared to the systems of the prior art combining a phase shifter and an attenuator, the systems requiring calibration for different values of phase shift between the two ways.

It is noted that, in the modulator 100, for the first signal S1, the individual phase shifter 110 applies a phase change to the first signal S1, in order to obtain a 90° phase difference with respect to second signal S2. With a perfect phase shifter, the individual phase shifter 110 should not introduce an amplitude change to first signal S1. In fact, the phase shifter 110 introduces a small amplitude change to the first signal S1. The attenuator 112 may be used to make up the amplitude change introduced by the individual phase shifter 110. Also, a perfect attenuator should not introduce a phase shift to the first signal. But in real conditions, the individual attenuator 112 introduces a small phase change. The individual phase shifter 110 may then be used to make up the small phase change introduced in the first signal by the individual attenuator 112. This process may be repeated several times, for example 2 or 3 times, to calibrate the first path 106 of the assembly 104.

The same applies to the second path 108 with the individual phase shifter 114 and the individual attenuator 116.

The calibration process is carried out until the first and the second paths are balanced so that, when the combination of the first and the second signals provides a combined signal with a phase of 45° +/- x°. This reduces the phase shift induced by the individual attenuators, and thus the overall calibration process of the modulator 100.

Consequently, even if there is a need for calibrating the individual phase shifters 110 and 114, and the individual attenuators 112 and 116, in order to obtain in phase quadrature first and second signals S1 and S2, this calibration is faster and easier compared to the prior art systems.

Moreover, a perfect combiner should not introduce a phase change into the combined signal. Here again, with real combiners there is always a small phase change introduced in the combined signal. It is possible to make up the small phase change introduced by the combiner 118 with the global phase shifter 120, during a calibrating phase.

Furthermore, a perfect global phase shifter should not modify the amplitude of the combined signal Sc. But, the global phase shifter 120 will introduce a small amplitude change into the combined signal Sc. The small amplitude change may be made up with the individual attenuators 112 and 116 of the assembly 104.

An example of a calibration process that allows quick and easy calibration of the modulator 200 will described further below.

The modulator 100 of the FIGURE 1 may also comprise a controller for adjusting or controlling:

- the phase shift PP applied to the input signal Sin, and
- optionally, the amplitude of the output signal Sout.

To do this, the controller 130 may be configured to control/adjust:

- the phase shift applied by the global phase shifter 120, and
- the relative amplitude of the first and the second signal. For example, the controller may adjust/control the gain of at least one, and in particular each, of the individual attenuators 112 and 116.

In some embodiments, the controller 130 may be configured to control the global phase shifter 120, each individual phase shifter 110 and 114, and each individual attenuator 112 and 116.

In the example shown in FIGURE 1 the assembly 104 comprises an individual phase sifter and an individual attenuator for each of the first and second signals.

In other embodiments, the assembly may not comprise individual phase shifter and/or an individual attenuator of the first signal, or for the second signal.

FIGURE 2 is a diagrammatic representation of another non-limitative example of a modulator according to the present invention.

The modulator 200, shown in FIGURE 2, may be used to modulate the phase of a RF signal, and in particular of a microwave signal, Sin, in order to obtain an output signal, Sout, the phase of which is shifted.

The modulator 200 comprises all the components of the modulator of the FIGURE 1, except the individual phase shifter 114. Thus, in the example of FIGURE 2, the phase shift of 90° between the first and the second signals S1 and S2 are obtained only through a phase shift applied to the first signal S1 by the individual phase shifter 110.

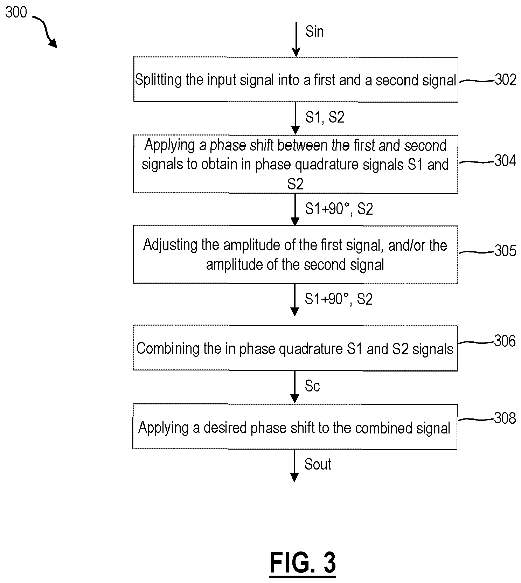

FIGURE 3 is a diagrammatic representation of a non-limitative example of a method according to the present invention.

The method 300, shown in FIGURE 3, may be used to modulate the phase of a RF signal, and in particular of a microwave signal, with a modulator according to the invention, and in particular with the modulator 100 of FIGURE 1 or the modulator 200 of FIGURE 2.

The method comprises a step 302 for splitting an input signal Sin into two signals: a first signal S1 and a second signal S2, with a splitter.

During a step 304 a phase shift is applied to at least one of the signals S1 and S2 in order to obtain a 90° phase difference between said first and second signals and delivering in phase quadrature first and second signals S1 and S2. The phase shift may be applied with an assembly comprising respective individual paths dedicated to each of the first signal S1 and second signal S2, as shown in FIGURE 2. The step 304 provides in phase quadrature signals S1 and S2.

At a step 305, the amplitude of at least one, and in particular each, of the first and second signals S1 and S2 are adjusted, for example with at least one attenuator.

At a step 306, the in phase quadrature signals S1 and S2 are combined with a combiner.

Finally, a phase shift is applied to the combined signals with a phase shifter at step 308, in order to obtain the output signal.

As indicated above, the modulator according to the invention may need to be calibrated.

The calibration phase described below, as a non-limitative example, may be used to calibrate the modulator 200 of FIGURE 2.

The calibration phase may comprise the following steps:

- the individual phase shifters 202 and 206, and the individual attenuators 204 and 208, of the first path 106 and the second path 108 are adjusted to obtain in phase quadrature first and second signals;
- the two individual attenuators 204 and 208 of the first and the second paths are adjusted independently and the amplitude and the added phase shifting for a 90° phase difference is recorded for each path 106 and 108;

- the individual phase shifters 202 and 206 are adjusted independently over a short range and the added amplitude is recorded;
- the range of the individual attenuators 204 and 208, and the range of the individual phase shifters 202 and 206 which could be used are determined by the added phase shifting and added amplitude depending on the required precision. The phase and the amplitude are controlled according to the following relations:

$$\angle V_r = arctan \frac{V_{90°}}{V_{0°}}$$

$$|V_r| = \sqrt{\left|V_{90°}^2\right| + \left|V_{0°}^2\right|}$$

with $\angle V_r$ the phase of the combined signal issued by the combiner and $|V_r|$ the amplitude of the combined signal issued by the combiner;

- the global phase shifter 112 is adjusted, in particular over 0°-360° range, and the induced amplitude change is compensated by the individual phase shifters 202 and 206, and the individual attenuators 204 and 208.

Of course, the invention is not limited to the examples detailed above. The modulator, respectively the method, according to the invention may comprise other components, respectively features, than those indicated above.

**Claims**

1. A modulator (100;200) for modulating the phase and the amplitude of a radiofrequency signal (Sin), called input signal, said modulator (100;200) comprising:

   - a splitter (102) for splitting the input signal (Sin) into a first signal (S1) and a second signal (S2);
   - an assembly (104) comprising:

     ▪ at least one individual phase shifter (110;114) for individually shifting the phase of at least one of the first and second signals (S1,S2) in order to obtain in phase quadrature first and second signals, and
     ▪ at least one individual attenuator (112,116) for individually adjusting the amplitude of at least one of the first and second signals (S1,S2);

   - a combiner (118) for combining said in phase quadrature first and second signals (S1,S2) output by said assembly (104), and delivering a combined signal (Sc); and
   - a global phase shifter (120) for applying a phase shift to said combined signal (Sc) and delivering an output signal (Sout).

2. The modulator (100;200) according to the preceding claim, **characterized in that** the global phase shifter (120) is an adjustable phase shifter.

3. The modulator (100;200) according to any one of the preceding claims, **characterized in that** the global phase shifter (120) is a 0-360° phase shifter.

4. The modulator (100;200) according to any one of the preceding claims, **characterized in that** the assembly (104) comprises a first path (106) dedicated to the first signal (S1) and a second path (S2) dedicated to the second signal (S2).

5. The modulator (100;200) according to any one the preceding claims, **characterized in that** the assembly (104) comprises:

   - an individual phase shifter (110) for the first signal (S1), and
   - an individual phase shifter (114) for the second signal (S2).

**EP 4 290 766 A1**

6. The modulator (100;200) according to the preceding claim, **characterized in that** at least one of the individual phase shifters (110,114) is an adjustable 0-360° phase shifter.

7. The modulator (200) according to any one the preceding claims, **characterized in that** the assembly (104) comprises:

    - an individual attenuator (112) for the first signal (S1), and
    - an individual attenuator (116) for the second signal (S2);

8. The modulator (100;200) according to the preceding claim, **characterized in that** at least one of the individual attenuators (112,116) is a controllable attenuator.

9. The modulator (100;200) according to the preceding claim, **characterized in that** it also comprises a controller (130) for adjusting or controlling:

    - the phase shift applied to the input signal (Sin), and
    - optionally, the amplitude of the output signal (Sout).

10. Use of a modulator (100;200) for simulating:

    - a direction of arrival of a received RF signal, or
    - a direction of emission of an emitted RF signal;

    by modulating the phase, and optionally the amplitude, of said RF signal.

11. A method (300) for modulating the phase and the amplitude of a radiofrequency, RF, signal (Sin), called input signal, with a modulator (100;200) according to any one of the claims 1 to 9, said method (300) comprising the following steps:

    - splitting (302) the input signal (Sin) into a first signal (S1) and a second signal (S2);
    - phase shifting (304) for applying a 90° phase difference between said first and second signals (S1,S2) and delivering in phase quadrature first and second signals;
    - adjusting (305) amplitudes of said first and second signals (S1,S2),
    - combining (306) said in phase quadrature first and second signals and delivering a combined signal (Sc); and
    - applying (308) a phase shift to said combined signal (Sc) and delivering an output signal (Sout).

12. The method (300) according to the preceding claim, further comprising a calibration phase of the modulator (100;200) for at least one desired phase shift value.

13. A computer program comprising instructions, which when executed by a computer, cause the computer to carry out:

    - the steps of the method (300) according to any one of the claims 11 or 12; or
    - the functions carried out by the modulator (100;200) according to any one of the claims 1 to 9.

9

**FIG. 1**

**FIG. 2**

300

↓ Sin

| Splitting the input signal into a first and a second signal |———302

↓ S1, S2

| Applying a phase shift between the first and second signals to obtain in phase quadrature signals S1 and S2 |———304

↓ S1+90°, S2

| Adjusting the amplitude of the first signal, and/or the amplitude of the second signal |———305

↓ S1+90°, S2

| Combining the in phase quadrature S1 and S2 signals |———306

↓ Sc

| Applying a desired phase shift to the combined signal |———308

↓ Sout

## FIG. 3

Europäisches
Patentamt
European
Patent Office
Office européen
des brevets

# EUROPEAN SEARCH REPORT

Application Number

EP 22 30 5818

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 5 504 465 A (YUNG MING L [US] ET AL) 2 April 1996 (1996-04-02) | 1-4,6-8, 11-13 | INV. H03C1/08 H03C3/40 H03C5/00 |
| Y | * column 3, line 13 - line 14; figures 1, 5 * | 9 | |
| X | US 5 172 394 A (KUSTER ANTON [CH] ET AL) 15 December 1992 (1992-12-15) | 1-8, 11-13 | |
| Y | * claim 3; figures 1,5, 6 * | 9 | |
| Y | US 9 774 299 B2 (FREESCALE SEMICONDUCTOR INC [US]; NXP USA INC [US]) 26 September 2017 (2017-09-26) * figure 1 * | 9 | |
| Y | WO 89/12364 A1 (MARTIN COMMUNICATIONS PTY LTD [AU]) 14 December 1989 (1989-12-14) * figure 1 * | 9 | |

TECHNICAL FIELDS
SEARCHED (IPC)

H03C

The present search report has been drawn up for all claims

| Place of search | Date of completion of the search | Examiner |
|---|---|---|
| The Hague | 22 November 2022 | Schnabel, Florian |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

Europäisches
Patentamt

European
Patent Office

Office européen
des brevets

**Application Number**

**EP 22 30 5818**

---

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☐ No claims fees have been paid within the prescribed time limit. The present European search report has been drawn up for those claims for which no payment was due.

---

## LACK OF UNITY OF INVENTION

The Search Division considers that the present European patent application does not comply with the requirements of unity of invention and relates to several inventions or groups of inventions, namely:

see sheet B

☐ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☒ **X** None of the further search fees have been paid within the fixed time limit. The present European search report has been drawn up for those parts of the European patent application which relate to the invention first mentioned in the claims, namely claims:

1-9, 11-13

☐ The present supplementary European search report has been drawn up for those parts of the European patent application which relate to the invention first mentioned in the claims (Rule 164 (1) EPC).

Europäisches
Patentamt

European
Patent Office

Office européen
des brevets

**LACK OF UNITY OF INVENTION
SHEET B**

Application Number

EP 22 30 5818

The Search Division considers that the present European patent application does not comply with the requirements of unity of invention and relates to several inventions or groups of inventions, namely:

**1. claims: 1-9, 11-13**

**Modulator comprising a splitter**
---

**2. claim: 10**

**Simulating a direction of arrival of a received RF signal**
---

## ANNEX TO THE EUROPEAN SEARCH REPORT
## ON EUROPEAN PATENT APPLICATION NO.

**EP 22 30 5818**

This annex lists the patent family members relating to the patent documents cited in  the above-mentioned European search report.
The members are as contained in the European Patent Office EDP file on
The European Patent Office is in no way liable for these particulars which are merely given for the purpose of information.

**22-11-2022**

| Patent document cited in search report | | Publication date | Patent family member(s) | | Publication date |
|---|---|---|---|---|---|
| US 5504465 | A | 02-04-1996 | NONE | | |
| US 5172394 | A | 15-12-1992 | DE | 3728020 A1 | 02-03-1989 |
| | | | EP | 0304737 A2 | 01-03-1989 |
| | | | JP | H0736493 B2 | 19-04-1995 |
| | | | JP | H01114202 A | 02-05-1989 |
| | | | US | 5172394 A | 15-12-1992 |
| US 9774299 | B2 | 26-09-2017 | US | 2016094187 A1 | 31-03-2016 |
| | | | US | 2017111014 A1 | 20-04-2017 |
| WO 8912364 | A1 | 14-12-1989 | NONE | | |

EPO FORM P0459

For more details about this annex : see Official Journal of the European Patent Office, No. 12/82